# DEMANDE DE BREVET EUROPEEN

(11) **EP 0 665 616 A1**
(43) Date de publication de la demande: **02.08.1995**
(21) Numéro de dépôt: 95400144.2
(22) Date de dépôt: 24.01.1995
(51) Int. Cl.: H01S 3/0941, H01S 3/025

(54) **Laser de grande puissance à deux étages**

(30) Priorité: 28.01.1994 FR 9400958
(71) Demandeur: THOMSON-CSF SEMICONDUCTEURS SPECIFIQUES, 75008 Paris (FR)
(72) Inventeur: Carriere, Claude, F-92402 Courbevoie Cedex (FR); Groussin, Bernard, F-92402 Courbevoie Cedex (FR); Larat, Christian, F-92402 Courbevoie Cedex (FR); Pocholle, Jean-Paul, F-92402 Courbevoie Cedex (FR)
(74) Mandataire: Guérin, Michel

(57) **Abrégé**

L'invention concerne un laser à l'état solide de grande puissance, associant une plaque émissive (12) de lasers semiconducteurs (4) (premier étage) qui pompent un laser solide (13) de type YAG (second étage).

La structure de la plaque émissive (12) qui est un circuit intégré, comprend une alternance de barrettes (2, 3) de lasers semiconducteurs (4) et de tranchées (9) entre ces barrettes (2, 3) qui sont parallèles entre elles. L'invention consiste à incruster le matériau des barreaux de laser solide (13) dans les tranchées (9) qui séparent les lasers semiconducteurs (4). Ce matériau est soit rapporté sous forme hybride, soit déposé sous forme intégrée.

Application aux lasers de très grande énergie lumineuse.

## Description

La présente invention concerne une structure de laser semiconducteur de grande puissance à deux étages, comportant un laser de moyenne puissance, en plaque à deux dimensions, qui pompe un matériau dit "lasant" lequel constitue un laser de grande puissance. La structure selon l'invention se distingue des structures connues en ce que les deux étages ne sont plus séparés et en regard l'un de l'autre comme dans l'art connu, mais s'interpénètrent, soit sous forme hybride, soit sous forme intégrée.

Les lasers solides à semiconducteurs, réalisés en matériaux III-V tels que GaAs, GaAlAs, GalnP ... etc, sont bien connus mais, qu'ils soient en éléments discrets ou en barrettes associant plusieurs lasers élémentaires, ils ne fournissent qu'une faible énergie en comparaison avec les lasers à gaz ou à excimères, par exemple, dont on sait que la puissance permet de découper la céramique, les métaux ou les tissus, ou des applications chirurgicales entre autres.

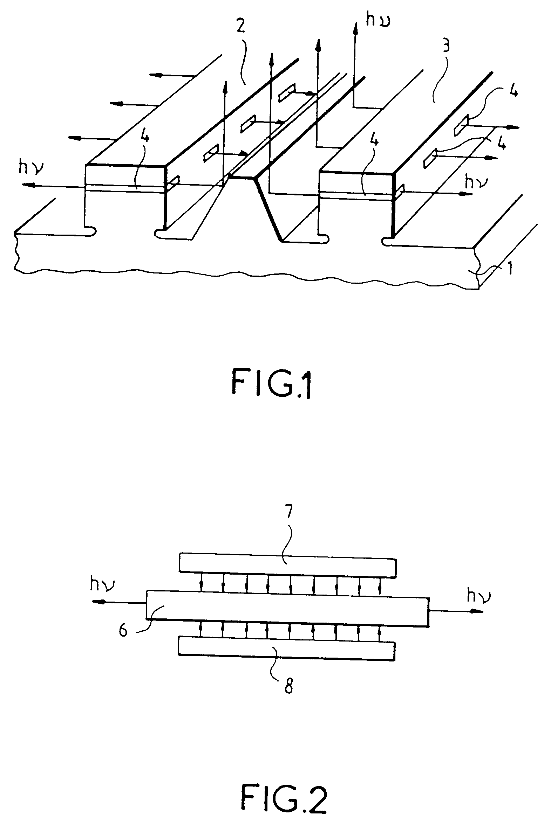

La faible puissance des lasers élémentaires ou même en barrettes a conduit à les associer en vue de former des plaques de circuits intégrés, regroupant une pluralité de barrettes de lasers disposées, sur un substrat, en alternance avec une pluralité de réglettes de réflecteurs à 45°, ce qui fait que le circuit intégré de lasers émet un rayonnement lumineux perpendiculairement à la surface principale du substrat. Un tel circuit intégré de lasers est décrit dans le Brevet français n° 2 639 150 déposé le 15 Novembre 1988 par la Demanderesse. La structure est brièvement évoquée par la figure 1, et seuls les éléments nécessaires à la compréhension sont dessinés et exposés. Un substrat 1 de matériaux semiconducteurs supporte une pluralité de barrettes parallèles entre elles telles que 2 et 3 dans lesquelles sont formées, en respectant toutes les règles de l'art, d'autres pluralités de lasers élémentaires 4. Les faces longitudinales des barrettes 2 et 3 perpendiculaires au plan principal du substrat 1, sont situées pour former des cavités de Fabry-Perrot, de sorte que les rubans lasers 4 émettent un rayonnement lumineux par les deux faces clivées des barrettes selon un plan parallèle au plan principal du substrat. Entre les barrettes 2 et 3, parallèles à elles, sont disposées des réglettes de miroirs, telles que 5, dont les flancs arrondis ou inclinés à 45° renvoient le rayonnement émis par les lasers perpendiculairement au plan principal du substrat.

Des plaques émissives selon ce concept ont été réalisées : leurs dimensions sont de l'ordre du centimètre de côté, et, par le regroupement de quelques centaines à quelques milliers de lasers élémentaires, de 100 µm, la puissance optique émise peut atteindre le kilowatt.

Pour monter encore en puissance crête émise et en pureté du spectre, il est connu d'associer un laser solide et au moins une plaque émissive de circuit intégré de lasers telle que décrite qui fournit l'énergie de pompage optique.

On appelle lasers solides, par opposition aux lasers semiconducteurs qui sont aussi à l'état solide, des barreaux de section ronde ou carrée, d'environ 5 cm x 5 mm ou des plaques en matériaux tels que les YAG (yttrium-aluminium-grenat), les YLF (yttrium-lithium-fluorure) ou le niobate de lithium LiNbO₃, tous dopés au néodyme, par exemple. Ces barreaux émettent une lumière cohérente dans les fenêtres centrées sur 1,06, 1,55 ou 2,1 µm respectivement, lorsqu'ils sont excités. De nombreuses publications sur ce sujet sont disponibles, parce que le pompage optique par lasers semiconducteurs a un rendement nettement meilleur que le pompage optique par une lampe flash limité à 1 % environ.

La figure 2 symbolise l'association d'un laser solide de YAG par exemple et d'un dispositif de pompage optique par lasers semiconducteurs: une plaque 6 de YAG est prise en sandwich par ses faces principales entre au moins deux plaques émissives de lasers 7 et 8, dont les faisceaux émis sont bien entendu tournés vers la plaque 6 de YAG qui produit une émission secondaire. Ce type d'association est connu par exemple du Brevet précité de la Demanderesse ou du Brevet US-A-5 115 445 du 19 Mai 1992. Cette figure 2 doit être interprétée dans un sens très large, car on connaît des exemples de laser solide 6 pompé par une pluralité de lasers semiconducteurs élémentaires ou en tablettes, dont l'énergie lumineuse est dirigée vers le laser solide 6 au moyen d'un système de miroirs ou par des fibres optiques.

Mais quelle que soit la forme géométrique que prend l'association du type de la figure 2 entre :
- un ou plusieurs lasers semiconducteurs,
- illuminant soit en direct, soit par renvoi au moyen de miroirs plans ou coniques, soit par fibre optique, soit par lentilles ou toutes autres combinaisons,
- un ou plusieurs lasers solides de type barreau cylindrique ou plaque,

il y a une caractéristique commune à toutes ces formes d'associations : les lasers de pompage optique sont géométriquement ou spatialement séparés, et ne forment pas un ensemble intégré. Ces associations de lasers primaire et secondaire peuvent former un ensemble homogène par des moyens mécaniques de fixation, mais les matériaux des lasers semiconducteurs et du laser solide (YAG) ne s'interpénètrent pas dans un plan.

Selon l'invention, un laser de grande puissance est formé par l'association d'une plaque émissive de lasers semiconducteurs intégrés, n'ayant donc qu'un seul substrat semiconducteur commun, et d'un matériau dit "lasant", pompable par les lasers semiconducteurs. La caractéristique de ce laser de grande puissance est que le matériau lasant qui constitue le laser secondaire, est incrusté entre les barrettes de lasers semiconducteurs de la plaque émissive intégrée et que ce laser de grande puissance est monolithique. Le matériau lasant est positionné entre les barrettes de lasers semiconducteurs en lieu et place des réglettes de miroirs 5 de la plaque émissive de l'art connu (figure 1) et ainsi l'axe principal de chaque barreau de matériau lasant se trouve dans le plan des rubans émetteurs des lasers semiconducteurs qui pompent transversalement le matériau actif, simultanément sur deux de ses faces. Le terme monolithique doit être pris dans un sens large car le laser selon l'invention peut être réalisé sous forme hybride, en rapportant des barreaux de matériau lasant dans les sillons entre barrettes de lasers semiconducteurs, ou sous forme intégrée par croissance ou dépôt du matériau lasant dans les mêmes sillons : que ce laser de grande puissance soit monolithique ne signifie pas qu'il soit monocristallin.

De façon plus précise, l'invention concerne un laser de grande puissance, à deux étages, comportant :
- un premier étage constitué par une plaque émissive à substrat unique comprenant une pluralité de lasers semiconducteurs intégrés en au moins deux barrettes parallèles entre elles et séparées par au moins une tranchée, ces lasers primaires émettant un rayonnement lumineux dans un plan parallèle au plan principal de la plaque émissive et selon une direction perpendiculaire aux faces latérales longitudinales des barrettes, ledit rayonnement lumineux fournissant l'énergie de pompage optique à :
- un second étage constitué par au moins un laser solide formé dans un matériau pompable par l'énergie émise par les lasers primaires, qui excitent ce laser secondaire ;

ce laser de grande puissance étant caractérisé en ce que le matériau du laser solide secondaire est incrusté dans la tranchée, entre les deux barrettes de lasers semiconducteurs qui illuminent par contact direct le laser solide par deux faces latérales longitudinales.

L'invention sera mieux comprise au moyen de la description qui suit de quelques exemples de réalisation, appuyée sur les figures jointes en annexes qui représentent :
- figure 1 : schéma de principe d'une plaque émissive de lasers semiconducteurs, selon l'art connu, exposé précédemment,
- figure 2 : schéma d'association d'un laser primaire semiconducteur et d'un laser secondaire solide, selon l'art connu, exposé précédemment,
- figure 3 : vue dans l'espace d'un fragment de la partie lasers semiconducteurs, selon l'invention,
- figure 4 : vue dans l'espace d'un fragment de laser de grande puissance selon l'invention, dans une première forme de réalisation,
- figure 5 : laser de grande puissance de la figure précédente, dont le laser secondaire a une géométrie différente,
- figure 6 : vue en coupe d'un fragment de laser de grande puissance selon l'invention, dans une deuxième forme de réalisation,
- figure 7 : vue en coupe d'une troisième forme de réalisation de l'invention, qui est le "complément" de la structure de la figure 6,
- figure 8 : vue en plan d'un laser de grande puissance à cavité accordable, selon l'invention,
- figure 9 : vue en coupe d'un montage de lasers avec pompage optique par trois faces, selon l'invention,
- figures 10 et 11 : vue en coupe de deux exemples d'association de lasers semiconducteurs intégrés et de lasers solides en éléments séparés selon l'invention,
- figures 12 et 13 : vue en coupe de deux exemples d'association de lasers semiconducteurs intégrés et de lasers solides monolithiques selon l'invention,
- figure 14 : vue en plan d'un montage optique sommateur de puissance selon l'invention.

Afin de simplifier l'exposé, et pour le clarifier, on conviendra d'appeler "lasers semiconducteurs" ou plaque émissive la partie de l'invention qui est le laser primaire, formé par une pluralité de barrettes de lasers élémentaires en GaAs/AlGaAs ou autres matériaux III-V tous ces lasers ayant la caractéristique d'être intégrés sur un unique substrat semiconducteur. On conviendra également que "laser YAG" concerne le laser secondaire de l'invention et désigne de façon générique tout matériau actif, dit lasant, qui n'est pas uniquement le YAG mais aussi le YLF ou le niobate de lithium, entre autres, ainsi que les fibres optiques en verre dopé.

De la même façon, les figures ne représentent qu'une petite fraction, élémentaire, du laser selon l'invention : pour obtenir la grande puissance recherchée, une plaque émissive comprend plusieurs dizaines de barrettes formées elles-mêmes de plusieurs dizaines de rubans lasers, dont la représentation précise serait illisible.

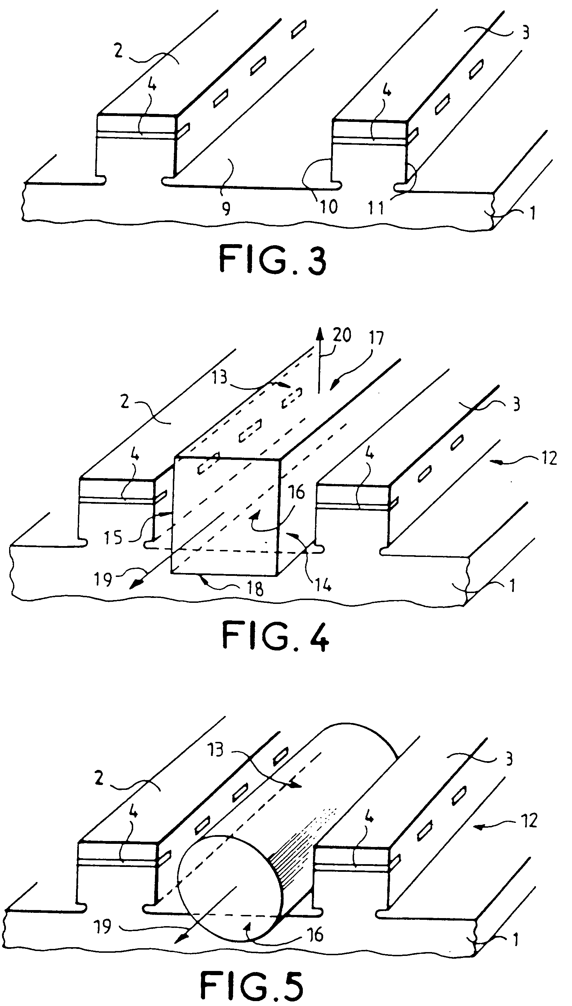

La figure 3 représente la partie "lasers semiconducteurs" de l'invention dans un premier mode de réalisation. C'est le produit de départ auquel on ajoutera ultérieurement la partie "laser YAG". Ce produit de départ comprend un substrat semiconducteur 1 qui supporte un réseau de barrettes 2 et 3 de diodes laser 4. Les barrettes sont parallèles entre elles et par opposition à l'art connu de la figure 1, il n'y a pas de réglette de miroirs entre chaque paire de barrettes, mais une tranchée 9, dont les dimensions sont de l'ordre de 50-250 µm de largeur entre deux barrettes, la longueur le long d'une barrette et la hauteur étant à peu de choses près celles d'une barrette 2 ou 3 de lasers 4.

Cette plaque de lasers semiconducteurs est réalisée selon le procédé décrit dans le Brevet français 2 639 150 précédemment cité, sauf en ce qui concerne les réglettes de miroirs 5 puisqu'il n'y en a pas. On peut cependant rappeler que sur un substrat 1 en GaAs par exemple, on fait croître par épitaxie, selon des procédés connus, les différentes couches de GaAs, AlGaAs, ou autres, convenablement dopées si nécessaire, qui constituent les couches d'arrêt, de sous-gravure, de confinement, de cavité ... etc, en toute conformité avec l'art. Ces dites couches, déposées sur toute la face libre du substrat 1, sont gravées pour créer les tranchées 9, puis les faces 10 et 11 des barrettes 2-3 sont clivées par ultrasons, selon une technique connue, de façon à former les miroirs des cavités de Fabry-Perrot. Les lasers semiconducteurs 4 sont de préférence à guidage par le gain, bien que, à ce stade, les métallisations de polarisation ne soient pas encore déposées. Les lasers semiconducteurs sont prévus pour pouvoir émettre dans le proche infrarouge, pour le pompage de terres rares, comme le néodyme Nd³⁺, l'ytterbium Yb³⁺ ou l'erbium Er³⁺ ou émettre dans le visible pour le pompage du chrome Cr³⁺ par exemple.

La plaque de lasers semiconducteurs de la figure 3 constitue le laser primaire d'un laser de grande puissance obtenu par l'adjonction d'un laser secondaire tel que représenté en figure 4. Dans une première forme de réalisation, un barreau de YAG 13 est inséré dans la tranchée 9 qui sépare deux barrettes 2 et 3 d'une plaque émissive qu'on désignera globalement par le repère 12. Le matériau lasant YAG est ainsi pompé transversalement par deux de ses faces opposées longitudinales 14 et 15, qui sont en contact intime ou très proche des faces clivées 10-11 des lasers semiconducteurs 4.

Le rayonnement de grande puissance émis par ce laser secondaire solide 13 peut être extrait de deux façons. Dans un premier cas d'extraction longitudinale, symbolisée par la flèche 19, les faces extrêmes 16 (et son opposée) sont polies, ou clivées selon le matériau et traitées pour extraire l'énergie parallèlement aux barrettes de lasers 2 et 3, par l'une ou par les deux faces extrêmes 16. Dans un second cas, les faces extrêmes 16 et la face inférieure longitudinale 18 qui repose sur le fond de la tranchée 9 sont traitées par métallisation pour faire miroir. L'énergie du laser secondaire est extraite par la seule face 17, selon une extraction transversale ou surfacique symbolisée par la flèche 20, dans une direction perpendiculaire au substrat 1 de la plaque 12 ou, ce qui revient au même, perpendiculairement aux barrettes de lasers 2 et 3.

La structure de la figure 4 est de type hybride en ce sens qu'une pluralité de barreaux 13 de YAG, préalablement usinés, sont fixés dans une pluralité de tranchées 9 d'un circuit intégré 12.

En pratique, il est avantageux de conserver pour le laser solide 13 une zone de gain à peu près de symétrie de révolution. Ainsi pour l'extraction "longitudinale" par exemple, la tranchée doit être à peu près deux fois plus large que profonde, soit typiquement 200 µm de large. Aussi pour obtenir de bons rendements, il est nécessaire d'utiliser un matériau à fort coefficient d'absorption pour que la puissance de pompe absorbée sur cette distance soit la plus grande possible. Par exemple, le coefficient d'absorption du YVO₄:Nd vers 810 nm est d'environ 40 cm⁻¹, ce qui correspond à 50 % de la puissance de pompe absorbée sur 200 µm. Cette valeur peut être améliorée :
- soit par l'utilisation de matériaux encore plus absorbants,
- soit par adaptation de la géométrie de la cavité laser pour que le faisceau soit plus large que haut, permettant d'augmenter la largeur du milieu actif et de la tranchée,
- soit par augmentation de la profondeur de la tranchée, et donc de sa largeur, par l'utilisation d'un substrat plus épais ou, si les problèmes thermiques sont trop importants, par gravure du support des diodes laser lui-même.

Le matériau lasant 13 est représenté sur la figure 4 sous la forme d'un barreau de YAG de section polygonale, c'est à dire carrée ou rectangulaire. Cette section n'est pas limitative de l'invention et la figure 5 représente une variante de l'invention selon laquelle le matériau lasant 13 du laser secondaire a une section circulaire et est un cylindre : dans ce cas, I'émission du laser secondaire ne peut se faire, bien entendu, que longitudinalement par les faces extrêmes qui sont adaptées. La forme cylindrique est avantageuse : les matériaux tels que le YAG sont plus facilement obtenus sous forme de fils de 200-250 µm de diamètre que sous forme de barreaux carrés dont il faut polir les faces longitudinales.

En outre, le cylindre 13 de la figure 5 peut être un élément de fibre optique dont le verre, ou silice, est dopé pour que le matériau soit pompable par le laser primaire semiconducteur. Les deux faces extrêmes de chaque fibre optique sont adaptées, pour créer une cavité de Fabry-Perrot, mais on verra plus loin que ceci n'est pas une obligation car la cavité peut être reportée à plus grande distance.

Mais plutôt que de rapporter des barreaux de matériau lasant 13 pour faire un dispositif hybride à partir d'un circuit intégré 12, il est possible de construire un laser de grande puissance totalement intégré.

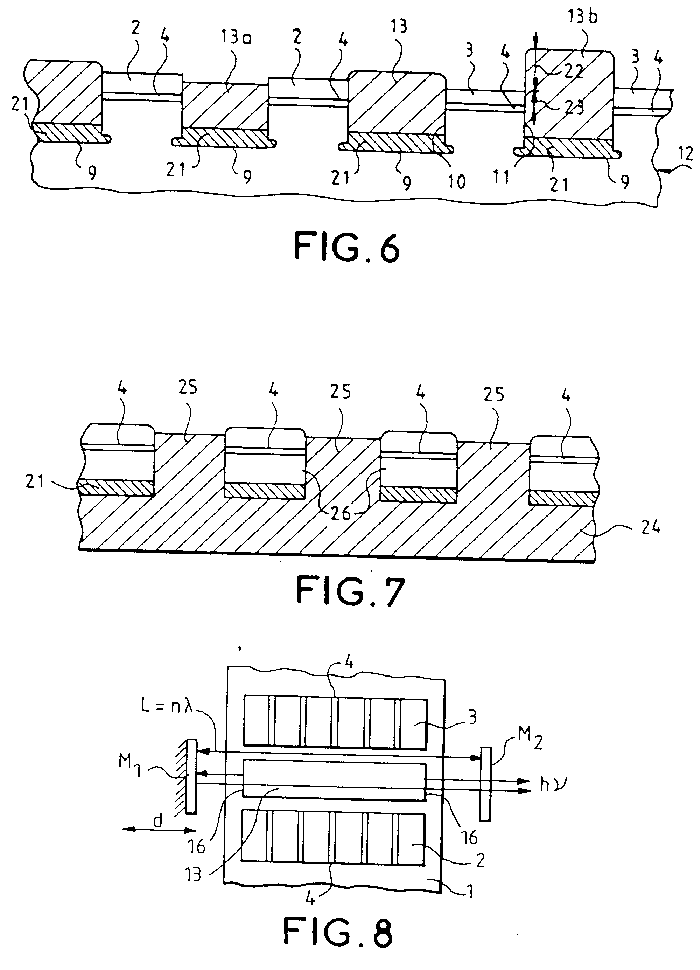

La figure 6 montre une vue en coupe d'un tel laser, dans une seconde forme de réalisation de l'invention.

De la plaque émissive 12 de lasers semiconducteurs, on n'a représenté, vu en coupe, que le strict minimum nécessaire à la compréhension de l'exposé : trois barrettes 2-3 de lasers 4, séparées par des tranchées 9, et supportées par un même substrat d'intégration. Les faces 10 et 11 des barrettes 2-3 ont été clivées, pour former les cavités résonnantes des lasers 4.

En utilisant la plaque émissive 12 comme substrat de départ, et au moyen de masques conformes à l'art en l'espèce, on fait croître par épitaxie ou par dépôt le matériau pompable 13 dans les tranchées 9 entre les barrettes 2-3 de lasers semiconducteurs 4 : les lasers primaires 12 et les lasers secondaires 13 sont donc intégrés en une même plaque émissive.

Bien entendu, il est nécessaire de déposer d'abord une ou plusieurs couches tampon 21 dans le fond des tranchées 9, indispensables à l'adaptation des maillages cristallographiques puisque, dans l'exemple choisi, GaAs a un cristal cubique à faces centrées et le YAG est rhomboëdrique. La nature de la ou des couches tampons 21 varie selon la nature des matériaux à accorder entre eux.

Le matériau du laser YAG 13 peut être obtenu par dépôt ou par croissance sur différentes épaisseurs. En figure 6, on a représenté en 13 et 1 3a à gauche, deux possibilités dans lesquelles ledit matériau remplit sensiblement la tranchée 9 jusqu'à affleurer, à peu près, le haut d'une barrette 2-3 ; c'est le cas le plus fréquent, et l'épaisseur de YAG doit être telle que le matériau du laser secondaire 13 monte jusqu'au plan des lasers 4 de la plaque 12 de laser primaire.

En 13b à droite, on a représenté une troisième possibilité selon laquelle le YAG est bien plus épais que les barrettes 2-3 qui le côtoient : cette surépaisseur d'épitaxie s'obtient facilement par masquage et lift-off. On verra ultérieurement l'utilité de ce troisième cas, pour lequel la surépaisseur 22, qui dépasse une barrette 3, doit être au moins égale à la distance 23 qui sépare le sommet de cette barrette 3 et le niveau d'un ruban laser 4.

Dans cette seconde réalisation intégrée, le matériau 13 qui remplit les tranchées 9 n'a pas de faces clivées. On ne sait pas transformer par clivage sa face supérieure 17 en miroir, et par conséquent il n'y a pas d'extraction surfacique de l'énergie du laser. L'émission lumineuse se fait par les faces extrêmes (16 sur la figure 4), en extraction longitudinale. Cliver ces faces extrêmes après avoir déposé une forte épaisseur de matériau tel que le YAG serait délicat, puisque le clivage suppose de casser une partie en porte-à-faux. Il est préférable de polir lesdites faces extrêmes 16 par gravure assistée par faisceau d'ions IBAE (Ion Beam Assisted Etching), méthode connue qui a déjà été citée, par exemple, par J.P. DONNELLY et al. dans Applied Physics Letters, 51 (15), du 12 Octobre 1987, pages 1138 et suivantes.

Le "complément" de la structure intégrée de la figure 6 est donné en figure 7. Par complément, il faut entendre que au lieu de faire croître le matériau YAG dans les tranchées 9 d'une plaque 12 de matériau semiconducteur III-V on fait dans le cas de la figure 7 croître les couches de matériaux III-V dans des tranchées usinées dans une plaque de YAG.

Une plaque 24 de YAG ou tout autre matériau pompable qui constituera le laser solide secondaire, est choisie suffisamment épaisse pour qu'il soit possible d'y graver, par exemple par gravure chimique sélective selon les plans cristallins, au moins deux barrettes 25 dont les faces verticales longitudinales 26 sont parallèles entre elles. Ces faces 26 sont usinées par faisceau d'ions pour avoir un état de surface miroir. Dans chaque tranchée entre deux barrettes 25, on fait croître par épitaxie ou CVD les matériaux III-V qui formeront des séries de lasers semiconducteurs 4 : il y a au moins une ou plusieurs couches 21 d'adaptation de paramètre de maille entre YAG et GaAs, puis au moins une couche active entre deux couches de confinement pour former un laser 4, dont la cavité optique est en contact intime avec les faces miroirs 26 du "peigne" de YAG.

Dans cette structure, I'émission secondaire par le laser YAG peut se faire par extraction longitudinale, par les extrémités des barrettes 25, ou par extraction surfacique par la face supérieure de ces mêmes barrettes 25, opposée au "substrat" 24, dont la face inférieure doit être traitée pour former une cavité de Fabry-Perrot.

Un laser de puissance selon la figure 7 est un second type de laser intégré.

On a envisagé, jusqu'à présent, que le laser solide 13 émet, dans le sens longitudinal, parce que ses deux faces extrêmes 16 sont clivées, ou polies, et traitées en miroir de façon à former une cavité de Fabry-Perrot dont la longueur est égale à la longueur du barreau ou du cylindre 13. Ce n'est pas le seul cas possible.

La figure 8 donne une vue en plan d'un autre cas de laser de puissance à cavité accordable, donc à fréquence, ou longueur d'onde, réglable. Cette figure représente un ensemble élémentaire comprenant un substrat 1, deux barrettes 2 et 3 de lasers primaires 4 et un barreau ou cylindre de matériau lasant 13, conformément à l'une des figures 4 à 7.

Les faces extrêmes 16 du barreau 13 sont polies, mais, dans ce cas, elles ne sont pas traitées en miroir pour former une cavité de Fabry-Perrot contenue entre elles deux. Selon cette variante de l'invention, les faces opposées de la cavité de Fabry-Perrot sont formées par deux glaces M1 et M2, situés sur l'axe optique du barreau 13, mais à l'extérieur de l'ensemble du laser de puissance. L'une des deux glaces, M1 par exemple, est traitée en miroir, et l'autre glace M2 est sans tain, et constitue la sortie du faisceau lumineux h 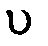 . Les deux glaces M1 et M2 sont situées à une distance L qui est un multiple de la longueur d'onde λ, que l'on peut régler à volonté en déplaçant au moins l'une des deux glaces d'une distance "d". Dans ce cas, le matériau 13 constitue un amplificateur de la lumière émise par les lasers primaires, et le véritable laser secondaire est la cavité formée entre les deux glaces M1 et M2.

Les figures 4 à 8 ne montrent, par souci de simplification, qu'un fragment de laser de puissance limité à un seul niveau dans l'espace : un jeu de lasers semiconducteurs d'un même circuit intégré 12 (figures 4 et 5) est associé à un jeu de lasers solides 13. Les groupements peuvent être différents, avec des structures qui se développent dans l'espace.

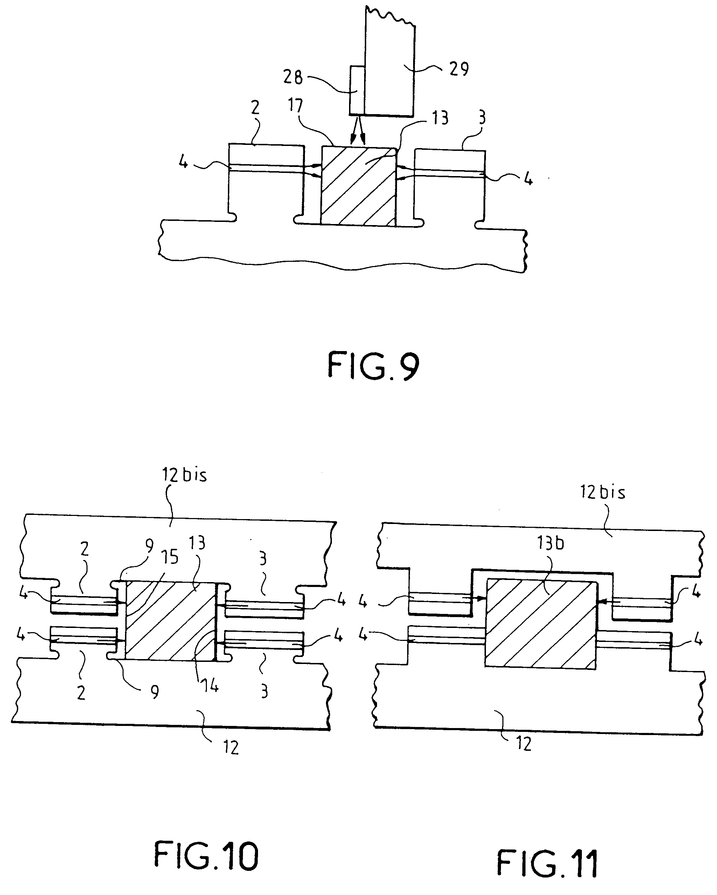

Un premier exemple en est donné en figure 9, sur laquelle on voit que, pour augmenter encore l'énergie de pompage d'un barreau de laser solide 13, inclus dans une plaque émissive semiconductrice 12, le barreau 13 est illuminé sur sa face longitudinale supérieure 17 par une barrette de lasers 28 montée sur un support 29. Cette barrette de lasers 28 est d'un type connu, obtenu soit en empilant des diodes lasers (stack), soit en découpant en rubans -et non plus en puces- une tranche de matériau semiconducteur sur laquelle on a réalisé collectivement des lasers.

Dans ce type de montage, le faisceau lumineux du laser YAG est extrait par l'une ou les deux faces extrêmes 16 selon le traitement qu'elles ont subi, mais le pompage optique d'un seul barreau de YAG se fait sur trois faces longitudinales, au moyen de trois systèmes de lasers primaires : deux barrettes 2-3 et une barrette 28.

La puissance de pompage optique peut encore être augmentée, en pompant sur deux faces longitudinales seulement mais au moyen de quatre systèmes de lasers primaires. La figure 10 en donne la représentation d'une forme hybride : un barreau 13 de YAG convenablement préparé, est pris en sandwich entre deux plaques émissives 12 et 12bis, soigneusement repérées pour que les tranchées 9 se correspondent et forment un tunnel dans lequel le barreau de YAG se place. Ainsi, les faces latérales longitudinales 14 et 15 du barreau de YAG sont pompées par les lasers 4 de quatre barrettes qui forment le tunnel.

La figure 11 représente le même type de montage mais sous forme intégrée. L'une des deux plaques émissives, 12 par exemple, comporte un barreau de YAG 13b qui dépasse en épaisseur les barrettes 2-3 de lasers semiconducteurs comme cela est représenté sur la partie droite de la figure 6. Une deuxième plaque émissive 12bis est ramenée sur la première plaque 12 de façon à prendre le barreau 13b de YAG en sandwich entre les deux plaques, comme en figure 8. Toutefois, pour pouvoir ajuster la deuxième plaque sur la première, il est préférable de prévoir que les tranchées 9 de la plaque mobile 12bis sont plus larges que celles de la plaque 12 sur laquelle on a fait croître le YAG 13b.

Dans ces deux cas des figures 10 et 11, le faisceau laser de grande puissance est obtenu par extraction longitudinale par les faces extrêmes des barreaux YAG.

En fait puisqu'il s'agit d'un laser de grande puissance obtenu par la coopération d'un grand nombre de lasers primaires semiconducteurs 4 et d'un autre grand nombre de lasers secondaires solides YAG 13, ceux-ci peuvent être intégrés en un objet monolithique, de même que la plaque émissive 12 est aussi un objet monolithique.

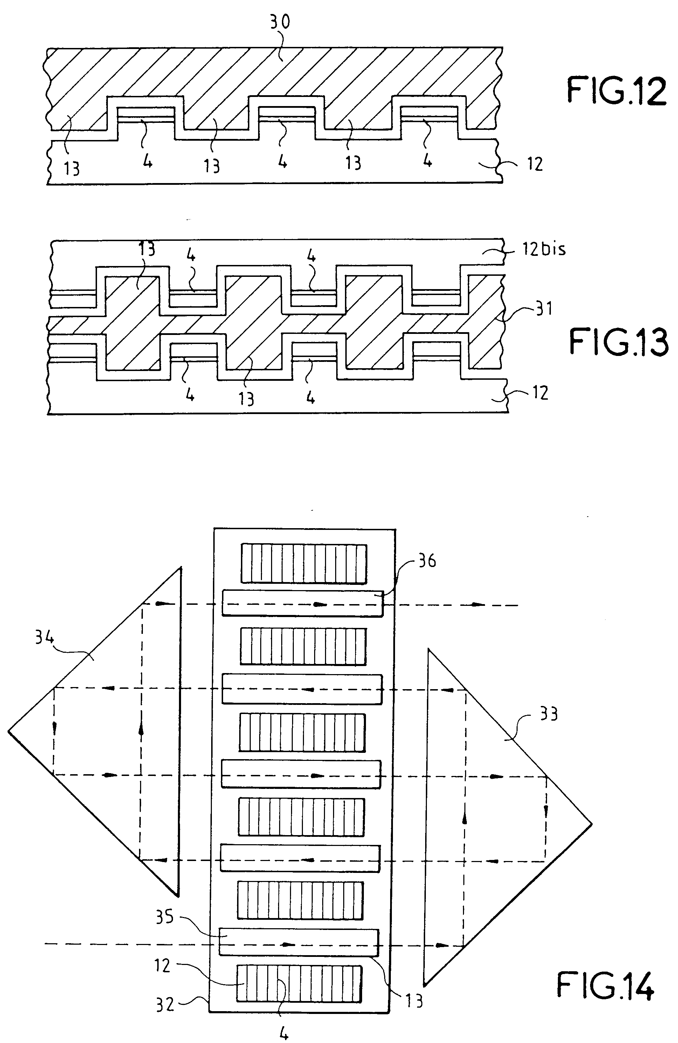

La figure 12 en donne une première forme : les différents barreaux 13 de YAG qui sont placés dans les tranchées entre barrettes de lasers 4 d'une plaque émissive 12 sont tous réunis en une seule plaque de YAG 30, qui est usinée, par exemple par voie chimique, en forme de peigne simple. Avec un peigne simple, il est possible d'émettre un faisceau lumineux par extraction surfacique, par la surface libre du peigne 30 de YAG. Mais il est également possible d'utiliser cette même surface libre du peigne 30 pour prendre un contact thermique avec un moyen radiateur, et l'extraction du faisceau laser est longitudinale.

La figure 12 correspond à la structure de la figure 4 dans laquelle une pluralité de barreaux 13 de YAG sont réunis en une plaque monolithique : de la même façon, la figure 13 correspond à la structure de la figure 10. Une plaque de YAG suffisamment épaisse, est usinée en forme de double peigne 31 avec deux séries de barreaux, et elle est insérée entre deux plaques émissives 12 et 12bis. Dans ce cas, les barreaux de YAG 13 qui constituent les dents du peigne sur ses deux côtés, sont préférentiellement en regard les unes des autres;

Enfin, la figure 14 représente une vue en plan d'un montage optique qui additionne les puissances optiques émises par tous les lasers secondaires du laser de grande puissance selon l'invention. Une pluralité de barrettes de lasers semiconducteurs 12 et une pluralité de barreaux de lasers solides 13 sont portées par un support commun 32. Celui-ci est soit un substrat GaAs par exemple, soit une plaque YAG par exemple, selon que ce montage est réalisé avec l'une ou l'autre des structures exposées précédemment (figures 4 à 13), mais avec émission longitudinale. Deux prismes 33 et 34 de rétro-réflexion sont disposés dans le plan défini par les faisceaux émis par les lasers YAG 13, un prisme de chaque côté du support 32 et avec sa plus grande face parallèle au bord du support 32, ou, ce qui revient au même, perpendiculaire aux faisceaux lumineux émis par les lasers YAG 13. On a représenté par un trait en pointillés l'axe optique du laser : les lois connues de l'optique montrent que les faisceaux émis par chacun des lasers YAG se réfléchissent sur les faces des prismes 33 et 34 selon le sens des flèches, et s'additionnent, d'où une plus grande puissance du laser.

Deux cas sont possibles. Dans le premier cas, représenté en figure 14, l'une des faces extrêmes de l'un des deux barreaux de YAG en bout d'alignement -la face 35 par exemple- est métallisée en miroir. L'énergie qui normalement sort par cette face est réfléchie par le miroir, et il n'y a qu'un seul faisceau lumineux selon le sens des flèches, de puissance double, qui est émis par la face 36, symétrique de la face 35 par rapport à l'ensemble du système.

Dans le second cas, la face 35 n'est pas métallisée, chaque laser YAG émet par ses deux faces clivées, et il y a deux faisceaux lumineux émis par les faces 35 et 36, selon deux directions opposées -la seconde direction n'est pas représentée par des flèches sur la figure 14.

La puissance de chacun de ces faisceaux est la moitié de celle émise dans le premier cas, mais elle est néanmoins la somme des puissances émises par chacun des barreaux de YAG 13.

De même que les figures 8,9 et 10 sont applicables à un laser secondaire formé par une fibre optique dopée, la figure 14 est tout à fait adaptée, sans aucune transformation, si les cylindres 13 sont des éléments de fibres optiques dopées.

En conclusion, l'invention est relative à un laser de grande puissance, comportant deux étages de lasers, un premier étage de lasers semiconducteurs primaires fournissant l'énergie nécessaire au pompage optique d'un second étage de lasers solides secondaires, l'association de ces deux étages se faisant par interpénétration des deux types de lasers qui sont interdigités, le matériau des lasers solides se trouvant en contact direct avec le matériau des lasers semiconducteurs et de plus placé dans le plan défini par les faisceaux émis par les lasers semiconducteurs qui sont intégrés en une plaque émissive.

Il est évident pour l'homme de l'art que les matériaux cités dans les exemples ne limitent pas la portée de l'invention, qui est définie par les revendications suivantes.

## Revendications

1. Laser de grande puissance, à deux étages, comportant :
- un premier étage constitué par une plaque émissive (12) à substrat unique comprenant une pluralité de lasers semiconducteurs (4) intégrés en au moins deux barrettes (2, 3) parallèles entre elles et séparées par au moins une tranchée (9), ces lasers primaires (4) émettant un rayonnement lumineux dans un plan parallèle au plan principal de la plaque émissive (12) et selon une direction perpendiculaire aux faces latérales longitudinales (10, 11) des barrettes (2, 3), ledit rayonnement lumineux fournissant l'énergie de pompage optique à :
- un second étage constitué par au moins un laser solide (13) formé dans un matériau pompable par l'énergie émise par les lasers primaires (4), qui excitent ce laser secondaire (13),
ce laser de grande puissance étant caractérisé en ce que le matériau du laser solide secondaire (13) est incrusté dans la tranchée (9), entre les deux barrettes (2, 3) de lasers semiconducteurs (4) qui illuminent directement le laser solide (13) par deux faces latérales longitudinales (14, 15).

2. Laser de grande puissance selon la revendication 1, caractérisé en ce que le second étage de laser solide est constitué par au moins un barreau de matériau pompable (13), rapporté dans au moins une tranchée (9) du premier étage de lasers semiconducteurs (4) selon une technologie de circuit hybride.

3. Laser de grande puissance selon la revendication 1, caractérisé en ce que le second étage de laser solide est constitué par un matériau pompable (13, 13a, 13b) rapporté dans au moins une tranchée (9) du premier étage de lasers semiconducteurs (4) selon une technologie de circuit intégré.

4. Laser de grande puissance selon la revendication 2, caractérisé en ce que le second étage de laser solide est constitué par au moins un barreau de section polygonale, carrée ou rectangulaire.

5. Laser de grande puissance selon la revendication 2, caractérisé en ce que le second étage de laser solide est constitué par au moins un cylindre.

6. Laser de grande puissance selon la revendication 1, caractérisé en ce que le support de la plaque émissive est en matériaux semiconducteurs de type III-V, tels que GaAs, AlGaAs, et en ce que le matériau pompable (13) des lasers solides est un matériau tel que les YAG (yttrium-aluminium-grenat), les YLF (yttrium-lithium-fluorure), ou le LiNbO₃, dopés au néodyme, le matériau des lasers solides étant rapporté sur la plaque émissive (12) des lasers semiconducteurs (4).

7. Laser de grande puissance selon la revendication 1, caractérisé en ce que le support de la plaque émissive est en matériaux semiconducteurs de type III-V, tels que GaAs, AlGaAs, et en ce que le matériau pompable (13) des lasers solides est une fibre optique en verre ou silice, dopée.

8. Laser de grande puissance selon la revendication 1, caractérisé en ce que le support de plaque émissive est en matériau pompable (24) tels que YAG, YLF, LiNbO₃, dans lequel sont usinés au moins deux barreaux (25) de lasers solides du second étage, barreaux dont les faces latérales longitudinales (26) sont traitées en poli miroir, les barrettes (27) de lasers semiconducteurs (4) du premier étage étant développées par épitaxie sur le support (24) des lasers solides du second étage.

9. Laser de grande puissance selon l'une quelconque des revendications 1 à 8, caractérisé en ce que les lasers solides (13) émettent par leurs faces extrêmes (16), en extraction longitudinale (19), lorsque lesdites faces d'extrémités sont adaptées pour que l'effet laser soit obtenu selon l'axe longitudinal.

10. Laser de grande puissance selon l'une quelconque des revendications 1 à 8, caractérisé en ce que les lasers solides (13) émettent par leur face longitudinale supérieure (17), en extraction transversale ou surfacique (20), lorsque la face longitudinale inférieure (18) est métallisée en miroir, et les faces extrêmes (16) non traitées.

11. Laser de grande puissance selon l'une quelconque des revendications 1 à 8, caractérisé en ce que les lasers solides (13) émettent par leurs faces extrêmes (16), non adaptées, la cavité de Fabry-Perrot étant formée par deux miroirs (M1,M2) situés sur l'axe longitudinal de chaque laser solide (13), la longueur d'onde émise étant réglable par la position des miroirs.

12. Laser de grande puissance selon la revendication 1, caractérisé en ce qu'au moins un barreau de laser solide (13), illuminé sur deux faces longitudinales latérales (14, 15) par deux barrettes (2, 3) de lasers semiconducteurs intégrés (4), est en outre illuminé sur une face longitudinale supérieure (17) par au moins une troisième barrette (28) de lasers semiconducteurs, portés par un socle (29) différent du support de la plaque émissive (12).

13. Laser de grande puissance selon la revendication 1, caractérisé en ce qu'au moins un barreau de laser solide (13, 13b) est pris en sandwich entre deux plaques émissives (12, 12bis) de lasers semiconducteurs (4) dont les tranchées (9) entre barrettes (2, 3) sont en vis-à-vis.

14. Laser de grande puissance selon la revendication 2, caractérisé en ce qu'une pluralité de barreaux (13) de lasers solides sont réunis en un peigne monolithique (30), dont le pas des barreaux (13) est identique au pas des tranchées (9) dans la plaque émissive de lasers semiconducteurs (4).

15. Laser de grande puissance selon les revendications 2 et 13, caractérisé en ce qu'une pluralité de barreaux (13) de lasers solides sont réunis en un double peigne monolithique (31), dont les barreaux (13) sur chaque face du peigne sont en regard et sont à un pas identique à celui des tranchées (9) des deux plaques émissives (12, 12bis) qui prennent en sandwich le double peigne (31).

16. Laser de grande puissance selon la revendication 1, caractérisé en ce que l'énergie lumineuse de grande puissance est recueillie par extraction longitudinale (19) dans le cas où les faces extrêmes (16) des barreaux (13) du second étage de laser solide sont adaptées.

17. Laser de grande puissance selon la revendication 1, caractérisé en ce que l'énergie lumineuse de grande puissance est recueillie par extraction surfacique (20) dans le cas où les faces longitudinales supérieures (17) des barreaux (13) du second étage de laser solide sont adaptées et les faces extrêmes (16) non adaptées.
